# EUROPEAN PATENT APPLICATION

(11) **EP 4 812 000 A1**
(43) Date of publication of application: **23.09.2026**
(21) Application number: 26150383.3
(22) Date of filing: 06.01.2026
(51) Int. Cl.: H10P 72/00

(54) **SUBSTRATE TREATING METHOD AND SUBSTRATE TREATING APPARATUS**

(30) Priority: 19.03.2025 JP 2025645780
(71) Applicant: SCREEN Holdings Co., Ltd., Kyoto-shi, Kyoto 602-8585 (JP)
(72) Inventor: NISHIMURA, Joichi, Kyoto, 602-8585 (JP); HAYASHI, Hideki, Kyoto, 602-8585 (JP)
(74) Representative: Goddar, Heinz J.

(57) **Abstract**

The present invention provides a substrate treating method in which a gap in a peripheral edge portion of a laminate substrate obtained by laminating a plurality of substrates is filled with a filler, the method comprising acquiring a first transmission image of the peripheral edge portion of the laminate substrate, filling the gap in the peripheral edge portion of the laminate substrate after acquisition of the first transmission image with the filler, acquiring a second transmission image of the peripheral edge portion after filling with the filler, and determining a filling state of the filler by comparing the first transmission image and the second transmission image.

## Description

### BACKGROUND OF THE INVENTION

### FIELD OF THE INVENTION

The present invention relates to a substrate treating method and a substrate treating apparatus for a laminate substrate obtained by laminating a plurality of substrates, which are capable of suppressing occurrence of breakage or chipping of an end portion of the laminate substrate and peeling of a substrate by filling a gap in a peripheral edge portion of the laminate substrate with a filler.

### DESCRIPTION OF RELATED ART

Three-dimensional mounting techniques in which a plurality of substrates with an integrated circuit or the like are laminated involve filling with a filler for preventing a defect of an end portion of a laminated substrate (laminate substrate). Accordingly, in subsequent steps such as a conveyance step, a step of thinning the laminate substrate, and a step of trimming an end portion, occurrence of breakage or chipping and peeling of a substrate at an end portion of the laminate substrate is prevented.

For example, JP 2023-32581 A discloses a substrate treating method in which a filler is applied to a gap in an edge portion of a laminate substrate obtained by bonding a first substrate and a second substrate, and is then cured, the edge portion of the laminate substrate after curing is imaged by an infrared imaging device, and the resulting image is used to determine a filling state of a filler. The prior art document indicates that by utilizing such a configuration, a laminate substrate that is defective in filling state of a filler can be prevented from being treated in subsequent steps.

However, even with the substrate treating method disclosed in JP 2023-32581 A, defective filling of a filler may occur. For example, even in a region extending inward from an edge portion to a center of a laminate substrate, a space may be formed due to defective filling of a filler. In such a case, the substrate treating method of the prior art document does not enable the filling state of a filler to be accurately determined. As a result, defective filling of a filler is overlooked, so that in subsequent steps such as a thinning step and a trimming step, breakage or chipping and peeling of a substrate occur at an end portion of a laminate substrate, and an expensive substrate on which a pattern has been formed is wasted.

### SUMMARY

The present invention has been made in view of the above-mentioned problems, and an object of the present invention is to provide a substrate treating method and a substrate treating apparatus which are capable of determining quality in filling state with respect to a filler filling a gap in a peripheral edge portion of a laminate substrate, and thus improving a yield.

To solve the above-described problems, the substrate treating method according to the present invention is a substrate treating method in which a gap in a peripheral edge portion of a laminate substrate obtained by laminating a plurality of substrates is filled with a filler, the method comprising a first transmission image acquisition step of acquiring a first transmission image of the peripheral edge portion of the laminate substrate, a filling step of filling the gap in the peripheral edge portion of the laminate substrate after acquisition of the first transmission image with the filler, a second transmission image acquisition step of acquiring a second transmission image of the peripheral edge portion after filling with the filler, and a determination step of determining a filling state of the filler by comparing the first transmission image and the second transmission image.

In the above-described configuration, the first transmission image acquisition step and the second transmission image acquisition step are each preferably a step of irradiating a peripheral edge portion of the laminate substrate in a substantially perpendicular direction with light having a wavelength that allows the light to pass through the laminate substrate, and acquiring the first transmission image or the second transmission image in plan view by receiving the light passing through the peripheral edge portion of the laminate substrate.

In the configuration, it is preferred to comprise a semi-curing step of semi-curing the filler filling the gap in the peripheral edge portion of the laminate substrate after the filling step and before the second transmission image acquisition step.

Further, in the configuration, it is preferred to repeat the filling step, the semi-curing step, the second transmission image acquisition step, and the determination step are repeated in sequence when a filling state of the filler is determined as being defective in the determination step.

In the configuration, it is preferred to comprise a curing step of curing the filler when a filling state of the filler is determined as being favorable in the determination step.

In the configuration, it is preferred to comprise a labeling step of performing labeling on a laminate substrate determined as being defective in filling state of the filler in the determination step.

To solve the above-described problems, the substrate treating apparatus of the present invention is a substrate treating apparatus for executing a substrate treating method having the above-described configuration, the substrate treating apparatus comprising a substrate holding unit that holds the laminate substrate, a transmission image acquisition unit that acquires a transmission image of a peripheral edge portion of the laminate substrate, a filling unit that fills a gap in the peripheral edge portion of the laminate substrate with the filler, and a control unit, in which the transmission image acquisition unit acquires the first transmission image before the filling unit fills the gap with the filler and the second transmission image after filling with the filler, and the control unit determines a filling state of the filler by comparing the first transmission image and the second transmission image.

In the above-described configuration, the transmission image acquisition unit preferably includes an irradiation unit that irradiates a peripheral edge portion of the laminate substrate in a substantially perpendicular direction with light having a wavelength that allows the light to pass through the laminate substrate, and an imaging unit that tales the first transmission image or the second transmission image in plan view by receiving the light passing through the peripheral edge portion of the laminate substrate.

In the configuration, a curing unit that semi-cures or cures the filler filling the gap of the peripheral edge portion of the laminate substrate is preferably provided.

In the configuration, the control unit preferably performs labeling on a laminate substrate determined as being defective in filling state of the filler.

The substrate treating method and the substrate treating apparatus of the present invention ensure that before a gap in a peripheral edge portion of the laminate substrate is filled with a filler, a first transmission image of the peripheral edge portion is acquired. In addition, a second transmission image of the peripheral edge portion is acquired after filling with the filler. A filling state of the filler is determined by comparing the first transmission image and the second transmission image. Thus, the present invention can provide a substrate treating method and a substrate treating apparatus which are capable of improving a yield.

### BRIEF DESCRIPTION OF THE DRAWINGS

Fig. 1 is a plan view showing a schematic configuration of a substrate treating apparatus according to a first embodiment;
Fig. 2 is an explanatory diagram schematically showing a substrate treating unit and an inspection unit in the substrate treating apparatus according to the first embodiment;
Fig. 3 is a block diagram showing a hardware configuration of a control unit in the substrate treating apparatus according to the first embodiment;
Fig. 4 is a block diagram showing an example of a functional configuration in the substrate treating apparatus according to the first embodiment;
Fig. 5 is a flowchart for illustrating a substrate treating method according to the first embodiment;
Fig. 6 is a partially enlarged sectional view showing a state in which a peripheral edge portion of a laminate substrate is irradiated with infrared light in the first embodiment;
Fig. 7 is a partially enlarged sectional view showing a state in which a gap in the peripheral edge portion of the laminate substrate is filled with a filler in the first embodiment;
Fig. 8 is a partially enlarged sectional view showing a state in which the peripheral edge portion of the laminate substrate which is filled with the filler is irradiated with infrared light in the first embodiment;
Fig. 9 is a partially enlarged sectional view showing a state in which the filler in the peripheral edge portion of the laminate substrate is cured by heating in the first embodiment;
Fig. 10 is a block diagram showing an example of a functional configuration in a substrate treating apparatus according to a second embodiment; and
Fig. 11 is a flowchart for illustrating a substrate treating method according to the second embodiment.

### DETAILED DESCRIPTION OF THE DISCLOSURE

### (First Embodiment)

A substrate treating apparatus and a substrate treating method according to a first embodiment of the present disclosure will be described below with reference to the drawings.

As used herein, the term "substrate " refers to various substrates such as a semiconductor substrate, a glass substrate for a photomask, a glass substrate for a liquid crystal display, a glass substrate for a plasma display, a substrate for a field emission display (FED), a substrate for an optical disk, a substrate for a magnetic disk, and a substrate for a magneto-optical disk. As used herein, the term "laminate substrate" refers to a substrate in which a plurality of substrates as mentioned above are bonded.

### [Substrate treating apparatus]

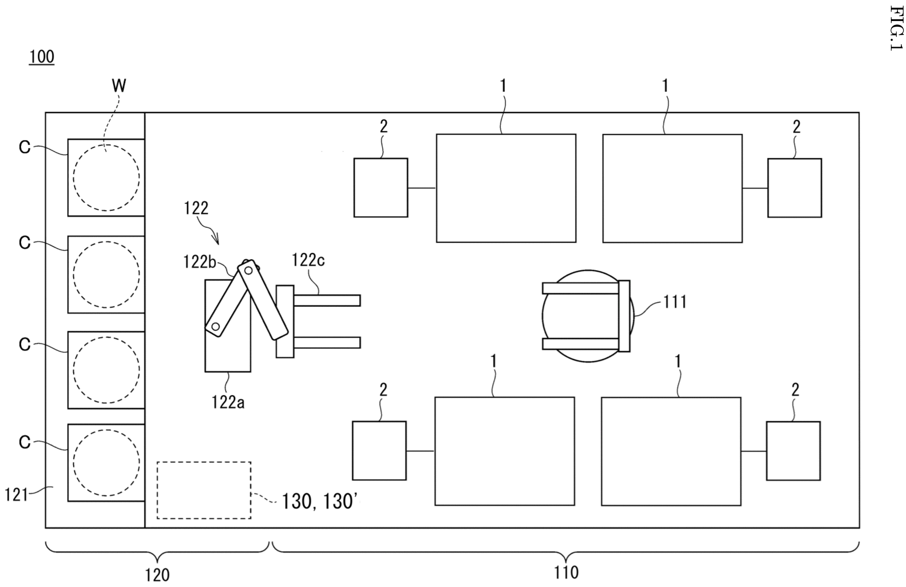

As shown in Fig. 1, a substrate treating apparatus 100 according to the present embodiment includes a substrate treating unit 110 that performs various types of treating on a laminate substrate Ws, an indexer unit 120, and a control unit 130 that controls the substrate treating apparatus 100. The substrate treating apparatus 100 of the present embodiment is a sheet-type substrate treating apparatus for use in various types of substrate treating. Fig. 1 is a plan view showing a schematic configuration of the substrate treating apparatus 100 according to the present embodiment.

### <Indexer unit>

The indexer unit 120 has a function of supplying the laminate substrate Ws to the substrate treating unit 110 or collecting the laminate substrate Ws from the substrate treating unit 110. Specifically, the indexer unit 120 includes four container holding units 121, and the container holding units 121 are each provided with one container C. Examples of the container C include a front opening unified pod (FOUP) that houses a plurality of laminate substrates Ws in a sealed state, a standard mechanical interface (SMIF) pod, and an open cassette (OC). In the present embodiment, a case where there are four container holding units 121 will be described as an example, but the present disclosure is not limited thereto. It is only required that there be a plurality of container holding units 121.

The indexer unit 120 further includes a first conveyance unit 122 for conveying the laminate substrate Ws. The first conveyance unit 122 is provided between the container holding unit 121 and the substrate treating unit 110. The first conveyance unit 122 includes a base portion 122a fixed to an apparatus housing, a multi-jointed arm 122b provided in a state of being allowed to rotate about a vertical axis with respect to the base portion 122a, and a hand 122c attached to a tip of the multi-jointed arm 122b. The hand 122c has a structure that enables the laminate substrate Ws to be placed and held on the upper surface of the hand 122c. The first conveyance unit 122 can access the container C held by the container holding unit 121 to take out the untreated laminate substrate Ws from the container C and house the treated laminate substrate Ws in the container C. The first conveyance unit 122 can also be called an indexer robot.

### <Substrate treating unit>

The substrate treating unit 110 engages in, for example, substrate treating that includes filling a gap in a peripheral edge portion of the laminate substrate Ws with a filler, and observation of a filling state of a filler in the peripheral edge portion. The substrate treating unit 110 includes a second conveyance unit 111 arranged substantially at the center in plan view, four substrate treating units 1 arranged so as to surround the second conveyance unit 111, and an inspection unit 2 that inspects the filling state of a filler in the peripheral edge portion of the laminate substrate Ws. Details of the substrate treating unit 1 and the inspection unit 2 will be described later.

As the second conveyance unit 111, for example, a substrate conveyance robot can be used. The second conveyance unit 111 randomly accesses each of the substrate treating units 1 to deliver the laminate substrate Ws. The substrate treating unit 110, which includes a plurality of substrate treating units 1 and inspection units 2, thus enables a plurality of laminate substrates Ws to be treated in parallel. The second conveyance unit 111 can also be called a center robot. A placement portion (path) for temporarily placing the laminate substrate Ws may be provided between the first conveyance unit 122 and the second conveyance unit 111.

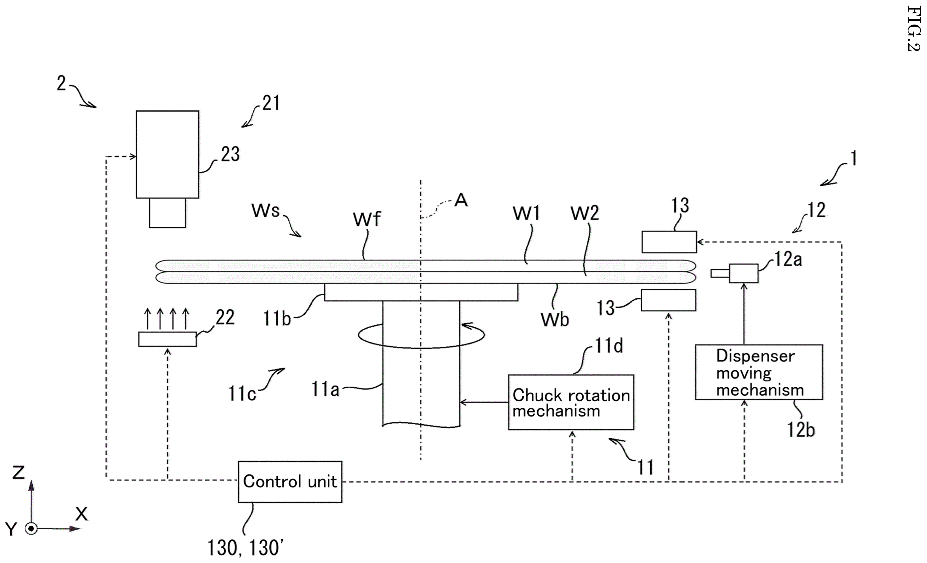

As illustrated in Fig. 2, the substrate treating unit 1 is a device for filling a gap in a peripheral edge portion of the laminate substrate Ws with a filler. The substrate treating unit 1 includes a substrate holding unit 11 that holds the laminate substrate Ws, a filling unit 12, and curing unit 13. Fig. 2 is an explanatory diagram schematically showing the substrate treating unit 1 and the inspection unit 2 in the substrate treating apparatus 100 according to the present embodiment. In the diagram, XYZ orthogonal coordinate axes are presented in order to clarify directional relationships between the illustrated matters. The XY plane represents a horizontal plane, and the +Z direction represents a vertically upward direction.

The substrate holding unit 11 is a unit that holds the laminate substrate Ws. As shown in Fig. 2, the laminate substrate Ws is rotated while being held in a substantially horizontal posture in a state where a surface Wf of the laminate substrate Ws (a surface of a first substrate W1) faces upward. The substrate holding unit 11 includes a spin chuck 11c in which a rotation support shaft 11a and a spin base 11b are integrally coupled. The spin base 11b has a substantially circular shape in plan view, and the hollow rotation support shaft 11a extending in a substantially vertical direction is fixed to a center portion of the spin base. The spin base 11b is connected to an intake system (not shown), and is configured to be capable of tightly holding a central portion of a back surface Wb of the laminate substrate Ws (a surface of the second substrate W2). The rotation support shaft 11a is connected to a rotation shaft of a chuck rotation mechanism 11d including a motor. Examples of the intake system include an aspirator and a vacuum ejector.

The chuck rotation mechanism 11d can be driven to rotate the rotation support shaft 11a about a rotation axis A by a chuck driving unit (not shown) of the control unit 130. Upon this, the spin base 11b attached to the upper end portion of the rotation support shaft 11a rotates around the rotation axis A at a constant speed. When the spin base 11b rotates, the laminate substrate Ws tightly held by the spin base 11b also rotates together with the spin base 11b, about a rotation axis parallel to a direction substantially perpendicular to the surface Wf of the laminate substrate Ws, that is, about the rotation axis A. The control unit 130 can control the chuck rotation mechanism 11d through the chuck driving unit to adjust the rotation speed of the spin base 11b.

The filling unit 12 has a function of discharging a filler, and is placed outside the laminate substrate Ws in the radial direction, where the laminate substrate Ws is placed in the substrate holding portion 11. The filling unit 12 includes, for example, a dispenser 12a and a dispenser moving mechanism 12b. The dispenser 12a is not limited, and examples thereof include a piezo dispenser, a syringe dispenser, a volumetric dispenser, a tubing dispenser, and a plunger dispenser. The dispenser 12a is electrically connected to the control unit 130, and discharges the filler when the control unit 130 instructs the dispenser 12a to operate. The dispenser 12a is arranged such that the filler can be discharged to a gap of a peripheral edge portion of the laminate substrate Ws. Further, the dispenser 12a includes a tank capable of storing a filler, and a valve that controls the discharge of the filler. The dispenser moving mechanism 12b moves the dispenser 12a horizontally and/or perpendicularly, for example. Thus, the distance between the laminate substrate Ws and the dispenser 12a is adjusted, so that the filler can be discharged to the gap between the first substrate W1 and the second substrate W2 in the peripheral edge portion of the laminate substrate Ws. The dispenser moving mechanism 12b is electrically connected to the control unit 130, and moves the dispenser 12a when the control unit 130 instructs the dispenser moving mechanism 12b to operate. The dispenser moving mechanism 12b may include a motor, and be able to rotate around an axis. It is possible to use a filler containing, for example, a thermosetting resin. The filler may contain an ultraviolet curable resin.

The curing unit 13 thermally cures the filler filling the gap between the first substrate W1 and the second substrate W2 by heating. The curing units 13 are arranged above the first substrate W1 and below the second substrate W2 so as to be opposed to each other in the peripheral edge portion of the laminate substrate Ws placed in the substrate holding unit 11. The curing units 13 are not in contact with the first substrate W1 and the second substrate W2, and are arranged at a predetermined distance from the substrates. Examples of the curing unit 13 include an air heater capable of applying hot air, and a lamp heater. When such a heater is used, the curing unit 13 can heat the laminate substrate Ws in a non-contact manner, so that it is also possible to thermally cure the filler with the laminate substrate Ws rotating about the rotation axis A.

The curing unit 13 may be arranged above the first substrate W1 or below the second substrate W2. Even in this configuration, the filler filled in the peripheral edge portion of the laminate substrate Ws can be thermally cured. As the curing unit 13, not only the air heater, the lamp heater, or the like, but also a hot plate may be used. In this case, the holding of the laminate substrate Ws by the substrate holding unit 11 is released, and the laminate substrate Ws is carried out and placed on the hot plate by the second conveyance unit 111 to thermally cure the filler in a filling state. Further, when an ultraviolet curable resin is used as the filler, an ultraviolet irradiation device can also be used as the curing unit 13. In this case, the ultraviolet irradiation device is arranged such that the gap in the peripheral edge portion of the laminate substrate Ws can be irradiated with an ultraviolet ray.

The inspection unit 2 is a unit that acquires a first transmission image before filling of the peripheral edge portion of the laminate substrate Ws with the filler and a second transmission image after filling with the filler (hereinafter, the first transmission image and the second transmission image may be each referred to simply as a "transmission image"), and inspects the filling state. The transmission image is an image acquired via transmitted light passing through the laminate substrate Ws. The transmission image is preferably an image of the laminate substrate Ws in plan view. As shown in Fig. 2, the inspection unit 2 includes a transmission image acquisition unit 21 that acquires a transmission image of the peripheral edge portion of the laminate substrate Ws, and the transmission image acquisition unit 21 further includes an irradiation unit 22 and an imaging unit 23.

The irradiation unit 22 is arranged on the peripheral edge portion of the laminate substrate Ws, and at a predetermined distance downward from the second substrate W2. The irradiation unit 22 irradiates the second substrate W2 with light in a direction substantially perpendicular to the surface of the second substrate W2. Examples of the irradiation unit 22 include a point light source, a line light source, and a surface light source. In the present embodiment, a surface light source is preferred in light of an irradiation region. The light applied by the irradiation unit 22 is light in a wavelength range that allows light to pass through the laminate substrate Ws. Specific examples of the light capable of passing through the laminate substrate Ws include infrared light whose wavelength is within a range of 1,000 nm to 2,500 nm. Preferably, the light emitted by the irradiation unit 22 does not pass through the filler filling the peripheral edge portion. This enables the filling state of the filler to be favorably determined in the transmission image obtained by the imaging unit 23. The irradiation unit 22 is electrically connected to the control unit 130, and performs irradiation with light when the control unit 130 instructs the irradiation unit 22 to operate.

For example, the imaging unit 23 detects light emitted from the irradiation unit 22 and passing through the laminate substrate Ws, such as infrared light, and produces an image signal. The imaging unit 23 is arranged on the peripheral edge portion of the laminate substrate Ws, and at a predetermined distance upward from the first substrate W1. The imaging unit 23 is arranged so as to face the irradiation unit 22 with the laminate substrate Ws interposed therebetween. Specifically, the imaging unit 23 includes, for example, a shutter, an imaging element capable of detecting the light, an A/D converter, a D/A converter, and the like (all of which are not shown). Examples of the imaging element include a CCD image sensor, and a CMOS image sensor. The A/D converter converts an image signal (analog value) output from the imaging element into a digital value to generate multivalued image data related to the transmission image. The D/A converter converts multivalued image data with a digital value into an analog value. This enables display on a display of a user interface (not shown). The imaging unit 23 is only required to be capable of producing image data. Therefore, the imaging unit 23 is not limited to the configuration of the present embodiment.

### <Control unit>

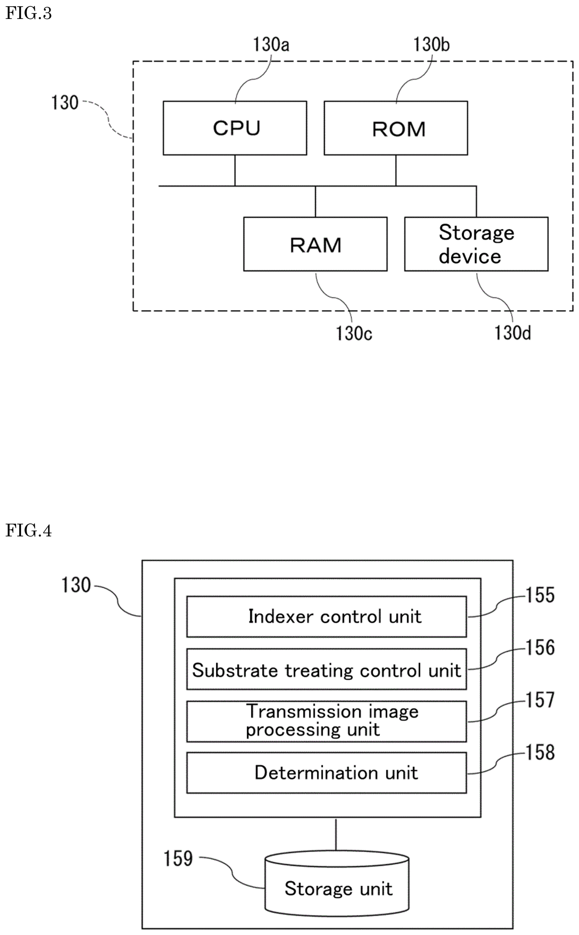

The control unit 130 is electrically connected to the units of the substrate treating apparatus 100, and controls the operation of each of the units. The control unit 130 includes a computer including an arithmetic processing unit and a memory (see Fig. 3). As the arithmetic processing unit, for example, a central processing unit (CPU) 130a that performs various types of arithmetic processing is used. As the arithmetic processing unit, a graphics processing unit (GPU) may be used. The memory includes a read only memory (ROM) 130b that is a read-only memory for storing a substrate treating program, a random access memory (RAM) 130c that is a readable/writable memory for storing various types of information, and a storage device 130d for storing control software, data, and the like, such as a magnetic disk. The CPU130a reads the program into the RAM130c and executes the program using the RAM130c as a work area. Fig. 3 is a block diagram showing a hardware configuration of the control unit 130.

From a function point of view, the control unit 130 includes at least an indexer control unit 155, a substrate treating control unit 156, a transmission image processing unit 157, a determination unit 158, and a storage unit 159 as shown in Fig. 4. Fig. 4 is a block diagram showing an example of a functional configuration of the control unit 130.

The indexer control unit 155 controls the first conveyance unit 122 and the like on the basis of, for example, an operation program stored in the storage unit 159. The operation program for the first conveyance unit 122 includes time-series instructions defined by at least one control parameter. Specific examples of the control parameter include a conveyance target position for the laminate substrate Ws and a speed of conveyance to the conveyance target position.

The substrate treating control unit 156 controls the second conveyance unit 111 on the basis of, for example, an operation program stored in the storage unit 159. The operation program for the second conveyance unit 111 includes time-series instructions defined by at least one control parameter. Specific examples of the control parameter include a conveyance target position for the laminate substrate Ws and a speed of conveyance to the conveyance target position. The substrate treating control unit 156 controls the substrate holding unit 11, the filling unit 12 and the curing unit 13 of the substrate treating unit 1 on the basis of an operation program stored in the storage unit 159. Examples of the control parameter in the operation program for the substrate treating unit 1 include a rotation speed of the laminate substrate (spin base 11b), filling conditions such as a filling amount of the filler, an arrangement position of the dispenser 12a, and curing conditions such as a heating time and a heating temperature. When an ultraviolet irradiation device is used for the curing unit 13, irradiation conditions such as an ultraviolet irradiation time and an irradiation intensity are also included. Further, the substrate treating control unit 156 also controls the irradiation unit 22, the imaging unit 23 and the like of the inspection unit 2 on the basis of an operation program stored in the storage unit 159. Examples of the control parameter in the operation program for the inspection unit 2 include irradiation conditions such as an irradiation time and an irradiation intensity for infrared light.

The transmission image processing unit 157 stores image data of the transmission image generated by the A/D converter of the imaging unit 23 in the storage unit 159. The transmission image processing unit 157 may be capable of bringing up the image data from the storage unit 159 and performing binarization processing to generate binarized image data. In this case, the transmission image processing unit 157 also stores the generated binarized image data in the storage unit 159. Specifically, in the binarization processing, for example, whether or not the gradation value is above a predetermined threshold is determined for each pixel. Conversion into black is performed in the case of being below the threshold, and conversion into white is performed in the case of being above the threshold. By performing the binarization processing, noise and the like can be removed, and the filling state of the filler is easily determined.

The determination unit 158 determines the quality of the filling state of the filler. More specifically, the determination unit 158 brings up the binarized image data of the first transmission image and the binarized image data of the second transmission image from the storage unit 159, and compares both data to determine the quality of the filling state of the filler. Here, the comparison is made by superimposing the binarized image data of the first transmission image and the binarized image data of the second transmission image to compare the pixels of the binarized image data of the first transmission image and the pixels of the binarized image data of the second transmission image. The quality of the filling state can be determined by, for example, whether or not comparison of the binarized image data of the second transmission image with the binarized image data of the first transmission image shows that there is a region which is not filled with the filler.

As described above, the storage unit 159 stores an operation program for controlling the indexer unit 120, and the substrate treating unit 1 and the inspection unit 2 of the substrate treating unit 110. The storage unit 159 stores inspection conditions including irradiation conditions and the like for the irradiation unit 22, substrate treating condition information (treating recipe) including filling conditions and curing conditions for the filler, control condition information for controlling the substrate treating apparatus 100, and the like. Further, the storage unit 159 also stores various types of data such as an identifier of the laminate substrate Ws, image data generated by the imaging unit 23, binarized image data generated by the transmission image processing unit 157, and label data related to the quality of the filling state of the filler.

### [Substrate treating method]

Next, a substrate treating method using the substrate treating apparatus 100 will be described below. In the substrate treating method according to the present embodiment, a transmission image of a peripheral edge portion of the laminate substrate Ws is acquired before and after filling of the peripheral edge portion with a filler, and the images are compared to determine the filling state. Thus, the substrate treating method of the present embodiment is capable of preventing a subsequent step such as a thinning step or a trimming step from being performed on a laminate substrate Ws that is defective in filling state of the filler. As a result, occurrence of breakage or chipping of an end portion of the laminate substrate Ws, peeling of the substrate, or the like is prevented or reduced, so that the yield can be improved.

### <Laminate substrate carrying-in step S1>

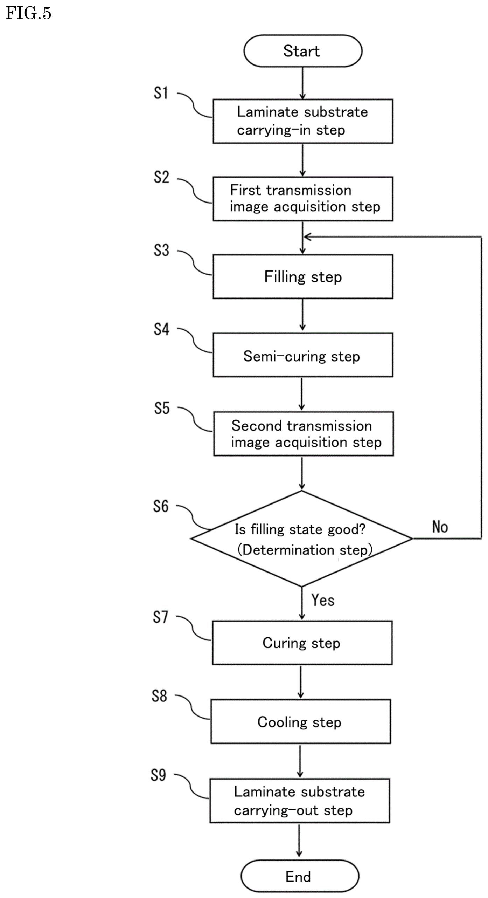

As shown in Fig. 5, first, a substrate treating program corresponding to a predetermined laminate substrate Ws is instructed to be executed by an operator, and an untreated laminate substrate Ws housed in a container C of the indexer unit 120 in a sealed state is delivered into the substrate treating unit 1 by the first conveyance unit 122 and the second conveyance unit 111. The laminate substrate Ws is placed on the spin base 11b, and tightly held on the spin base 11b by an intake system (not shown). The untreated laminate substrate Ws is held in a substantially horizontal posture by the substrate holding unit 11. Fig. 5 is a flowchart for illustrating a substrate treating method according to the present embodiment.

### <First transmission image acquisition step S2>

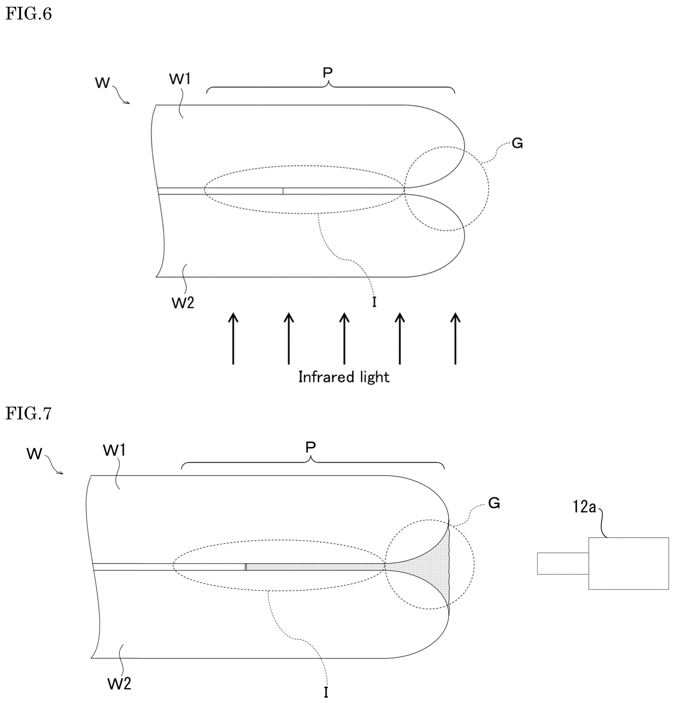

Next, a first transmission image of the peripheral edge portion of the laminate substrate Ws is acquired. That is, in response to an operation instruction from the control unit 130, the chuck rotation mechanism 11d is controlled through a chuck driving unit to rotate the laminate substrate Ws tightly held on the spin base 11b. As shown in Fig. 6, the irradiation unit 22 is arranged immediately below the peripheral edge portion P of the laminate substrate Ws, and the imaging unit 23 is oppositely arranged with the laminate substrate Ws interposed therebetween, followed by positioning. Fig. 6 is a partially enlarged sectional view showing a state in which the peripheral edge portion P of the laminate substrate Ws is irradiated with infrared light. In response to an operation instruction from the control unit 130, the peripheral edge portion P of the rotating laminate substrate Ws is irradiated with infrared light from below. Here, the peripheral edge portion P means a predetermined range inside an outer peripheral edge (end portion) forming the contour of the laminate substrate Ws. Specifically, as shown in Fig. 6, the peripheral edge portion P includes bevel portions at end portions of a first substrate W1 and a second substrate W2, and a gap G formed by the bevel portion of the first substrate W1 and the bevel portion of the second substrate W2, as well as an internal region I extending inward by a predetermined distance (for example, 2 mm or less) from the outer peripheral edge to the center of the laminate substrate Ws.

The irradiation with infrared light by the irradiation unit 22 is controlled by the control unit 130 so that the irradiation direction is substantially perpendicular to a surface Wf of the laminate substrate Ws. When the irradiation direction is substantially perpendicular to the surface Wf of the laminate substrate Ws, it is possible to image the internal region I of the laminate substrate Ws. Irradiation conditions such as an irradiation time and an irradiation intensity are not limited, and are appropriately set.

When the irradiation unit 22 emits infrared light, the imaging unit 23 receives the transmitted light passing through the peripheral edge portion P of the laminate substrate Ws. The transmitted light received is output as an analog value image signal in the imaging element. Further, the analog value image signal is converted into a digital value in an A/D converter to generate multivalued image data. The multivalued image data is stored in the storage unit 159 by the transmission image processing unit 157. The transmission image processing unit 157 brings up the image data from the storage unit 159, and performs binarization processing to generate binarized image data (first transmission image).

The number of imaging regions (measurement points) for acquiring the first transmission image may be 1, or 2 or more. When there are a plurality of imaging regions, the first transmission image of the peripheral edge portion P of the laminate substrate Ws may be acquired at a preset measurement point during one rotation of the laminate substrate Ws. For example, the laminate substrate Ws is positioned at a predetermined location, then rotated to a first rotation angle to acquire an initial first transmission image, and further rotated to acquire a next first transmission image at a second rotation angle. By sequentially acquiring the first transmission image at each of the predetermined rotation angles in the manner described above, first transmission images corresponding to respective rotation angles of the laminate substrate Ws can be acquired. The number of first transmission images that can be acquired is, for example, 100 to 150.

### <Filling step S3>

Subsequently, the gap G of the peripheral edge portion P of the laminate substrate Ws is filled with a filler. That is, the control unit 130 instructs the dispenser moving mechanism 12b to operate, so that the dispenser 12a is moved horizontally and/or vertically, and arranged such that the filler can be discharged to the gap G of the peripheral edge portion P of the laminate substrate Ws. Subsequently, in response to an operation instruction from the control unit 130, the chuck rotation mechanism 11d is controlled through a chuck driving unit to rotate the laminate substrate Ws tightly held on the spin base 11b. In response to the operation instruction from the control unit 130, the dispenser 12a of the filling unit 12 continuously discharges the liquid filler to the gap G while the laminate substrate Ws is rotated (see Fig. 7). In this way, the gap G is filled with the filler over the entire peripheral edge portion P of the laminate substrate Ws. Fig. 7 is a partially enlarged sectional view showing a state in which the gap G in the peripheral edge portion P of the laminate substrate Ws is filled with the filler.

### <Semi-curing step S4>

Next, the filler filling the gap G of the peripheral edge portion P of the laminate substrate Ws is semi-cured. That is, with the laminate substrate Ws rotated by the substrate holding unit 11, the control unit 130 instructs the curing unit 13 to operate, so that heat is applied from above the first substrate W1 and below the second substrate W2. In this way, the filler filling the gap G can be semi-cured over the entire peripheral edge portion P of the laminate substrate Ws. The term "semi-cured" as used herein refers to a state in which the viscosity of the filler increases, and the filler is not completely cured. Heating conditions such as a heating time and a heating temperature for semi-curing the filler are appropriately set according to, for example, a type and a filling amount of the filler. When an ultraviolet curable resin is used as the filler, the gap G of the peripheral edge portion P of the laminate substrate Ws is irradiated with an ultraviolet ray by an ultraviolet irradiation device as the curing unit 13 to semi-cure the filler. In this case, irradiation conditions such as an irradiation time and a light intensity are appropriately set according to, for example, a type and a filling amount of the filler.

### <Second transmission image acquisition step S5>

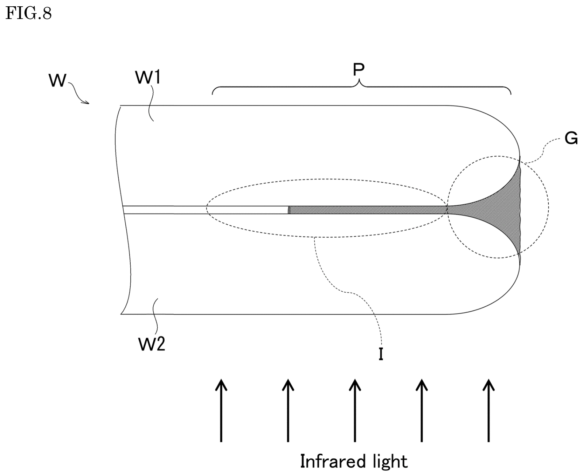

Subsequently, the second transmission image of the peripheral edge portion of the laminate substrate Ws filled with the filler is acquired in the same manner as in the first transmission image acquisition step S2. That is, in response to an operation instruction from the control unit 130, the chuck rotation mechanism 11d is controlled to rotate the laminate substrate Ws. The irradiation unit 22 is arranged immediately below the peripheral edge portion P of the laminate substrate Ws, and the imaging unit 23 is oppositely arranged with the laminate substrate Ws interposed therebetween. Subsequently, the control unit 130 controls the irradiation unit 22 to irradiate the peripheral edge portion P of the laminate substrate Ws with infrared light from below the second substrate W2 as illustrated in Fig. 8. Fig. 8 is a partially enlarged sectional view showing a state in which the peripheral edge portion P of the laminate substrate Ws which is filled with the filler is irradiated with infrared light. When the irradiation unit 22 emits infrared light, the imaging unit 23 receives the transmitted light passing through the peripheral edge portion P of the laminate substrate Ws. As in the case of the first transmission image acquisition step S2, the transmitted light received is output as an analog value image signal in the imaging element, and then converted into a digital value in an A/D converter to generate multivalued image data. Further, the multivalued image data is stored in the storage unit 159 by the transmission image processing unit 157. The transmission image processing unit 157 brings up the image data from the storage unit 159, and performs binarization processing to generate binarized image data (second transmission image). Here, the semi-cured filler filling the peripheral edge portion P is not permeable to infrared light. Therefore, in the second transmission image, the filling state of the filler in the peripheral edge portion P can be confirmed. Irradiation conditions such as an irradiation time and an irradiation intensity are appropriately set.

The imaging regions (measurement points) for acquiring the second transmission image are preferably identical to the imaging regions (measurement points) in the first transmission image acquisition step S2. When there are a plurality of imaging regions, as in the case of the first transmission image acquisition step S2, the second transmission image of the peripheral edge portion P of the laminate substrate Ws may be acquired at a preset measurement point during one rotation of the laminate substrate Ws. That is, for example, the laminate substrate Ws is positioned at a predetermined location, then rotated to a first rotation angle to acquire an initial second transmission image, and further rotated to acquire a next second transmission image at a second rotation angle. By sequentially acquiring the second transmission image at each of the predetermined rotation angles in the manner described above, second transmission images corresponding to respective rotation angles of the laminate substrate Ws can be acquired. The number of second transmission images that can be acquired is, for example, 100 to 150.

### <Determination step S6>

In the present step, the quality of the filling state of the filler is determined. That is, the determination unit 158 brings up the binarized image data of the first transmission image and the binarized image data of the second transmission image from the storage unit 159, and compares both data to determine the quality of the filling state of the filler. Here, the imaging regions in the first transmission image acquisition step S2 and the second transmission image acquisition step S5 each include a gap G formed by the bevel portions of the first substrate W1 and the second substrate W2, as well as an internal region I extending inward by a predetermined distance from the outer peripheral edge to the center of the laminate substrate Ws. Therefore, in the determination of the quality of the filling state, not only the gap G but also the internal region I extending inward can be covered. Thus, as compared to conventional substrate treating methods, occurrence of breakage and chipping at the end portion of the laminate substrate Ws and peeling of the first substrate W1 or the second substrate W2 in the subsequent steps can be more favorably prevented, so that the yield can be improved. The binarized image data of the first transmission image and the binarized image data of the second transmission image, which are acquired for the same imaging region (for example, locations at which the rotation angles of the laminate substrate Ws are the same), can be compared.

When the filling state of the filler is determined as being favorable in the present step, a curing step S7 which will be described later is performed. On the other hand, when the filling state of the filler is determined as being defective, the filling step S3, the semi-curing step S4 and the second transmission image acquisition step S5 are performed again.

### <Curing step S7>

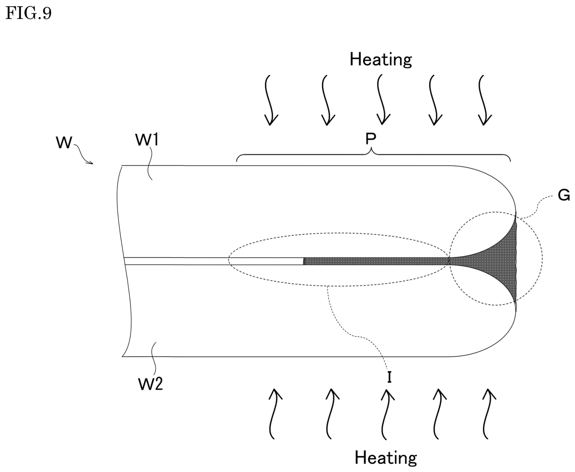

In the present step, the filler filling the gap G of the peripheral edge portion P of the laminate substrate Ws determined as being excellent in filling state of the filler is completely cured. That is, in response to an operation instruction from the control unit 130, the chuck rotation mechanism 11d is controlled through a chuck driving unit to rotate the laminate substrate Ws tightly held on the spin base 11b. In a state where the laminate substrate Ws is rotated, the control unit 130 instructs the curing unit 13 to operate, so that heat is applied from above the first substrate W1 and below the second substrate W2. In this way, the filler filling the gap G can be completely cured over the entire peripheral edge portion P of the laminate substrate Ws (see Fig. 9). Fig. 9 is a partially enlarged sectional view showing a state in which the filler in the peripheral edge portion P of the laminate substrate Ws is cured by heating. Heating conditions such as a heating time and a heating temperature for completely curing the filler are appropriately set according to, for example, a type and a filling amount of the filler. By ensuring that the heating time or the heating temperature does not become insufficient, the filler can be sufficiently cured to prevent adhesion failure of the filler and a decrease in mechanical strength can be prevented. By ensuring that the heating time or the heating temperature does not become excessive, a decrease in throughput can be suppressed. When an ultraviolet curable resin is used as the filler, the gap G of the peripheral edge portion P of the laminate substrate Ws is irradiated with an ultraviolet ray by an ultraviolet irradiation device as the curing unit 13 to completely cure the filler. In this case, irradiation conditions such as an irradiation time and a light intensity are appropriately set according to, for example, a type and a filling amount of the filler.

### <Cooling Step S8>

In the present step, the filler that is completely cured by heating in the curing step S7 is cooled. The cooling method is not limited, and examples thereof include a method using a cooling plate (not shown.). The cooling plate is arranged, for example, above the spin base 11b and below the laminate substrate Ws. In this case, the laminate substrate Ws may be held by a sandwiching member or the like. Preferably, the cooling plate has an upper surface facing the second substrate W2 of the laminate substrate Ws, and does not rotate even when the chuck rotation mechanism 11d rotates. The cooling plate is electrically connected to the control unit 130, and cools the laminate substrate Ws upon an operation instruction from the control unit 130. The upper surface of the cooling plate can provide uniform cooling. Thus, laminate substrate Ws can be uniformly cooled from the second substrate W2 side. By cooling the laminate substrate Ws, the thermally cured filler filling the peripheral edge portion P can be cooled. The present step may be omitted when an ultraviolet curable resin is used as the filler.

### <Laminate substrate carrying-out step S9>

After completion of the cooling step S8, control unit 130 controls dispenser moving mechanism 12b to position dispenser 12a at a retracted location from a location where the filler can be supplied. Thereafter, the second conveyance unit 111 enters the internal space of the substrate treating unit 1, and unloads the treated laminate substrate Ws released from being tightly held by the spin base 11b from the substrate treating unit 1, and a series of substrate treating is ended.

As described above, in the present embodiment, the first transmission image of the peripheral edge portion P is acquired before the gap G of the peripheral edge portion P of the laminate substrate Ws is filled with the filler. Further, the second transmission image of the peripheral edge portion P after filling with the filler is acquired. The first transmission image and the second transmission image are compared to determine the quality of the filling state of the filler, and when the filler is determined as being defective, refilling with the filler is carried out. Therefore, in the present embodiment, occurrence of breakage or chipping of an end portion of the laminate substrate Ws and peeling of the substrate in subsequent steps such as a step of thinning the laminate substrate Ws and a step of trimming an end portion of the laminate substrate Ws can be prevented to improve the yield.

### (Second Embodiment)

A second embodiment of the present disclosure will be described below.

### [Substrate treating apparatus]

### <Overall configuration of substrate treating apparatus and substrate treating unit>

The substrate treating apparatus according to the second embodiment is substantially identical in configuration to the substrate treating apparatus 100 according to the first embodiment with the exception of the control unit (see Fig. 1). Therefore, the substrate treating unit 110 and the indexer unit 120 are denoted by the same reference numerals, and detailed descriptions thereof are omitted.

### <Control unit>

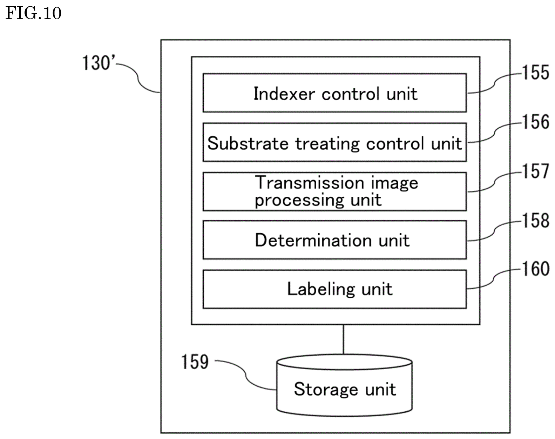

A control unit 130' of the present embodiment is similar in hardware configuration to the control unit 130 of the first embodiment. However, from a function point of view, the control unit 130' is mainly different in that it further includes a labeling unit 160 as shown in Fig. 10. Fig. 10 is a block diagram showing an example of a functional configuration of the control unit 130' according to the present embodiment.

The labeling unit 160 performs labeling on a laminate substrate Ws. Specifically, the labeling unit 160 associates label data with the identifier of a laminate substrate Ws determined as being defective in filling state of the filler by a determination unit 158, followed by storage in a storage unit 159. The labeling by the labeling unit 160 may be performed on a laminate substrate Ws determined as being excellent in filling state. In this case, another label data is associated with the identifier of the laminate substrate Ws determined as being excellent in filling state, followed by storage in the storage unit 159.

### [Substrate treating method]

Next, a substrate treating method according to the present embodiment will be described below. In the substrate treating method of the present embodiment, labeling is performed on a laminate substrate Ws determined as being defective in filling state of the filler by the determination unit 158, followed by discarding or the like. Thus, the substrate treating method of the present embodiment is capable of preventing a subsequent step such as a thinning step or a trimming step from being performed on a laminate substrate Ws that is defective in filling state of the filler.

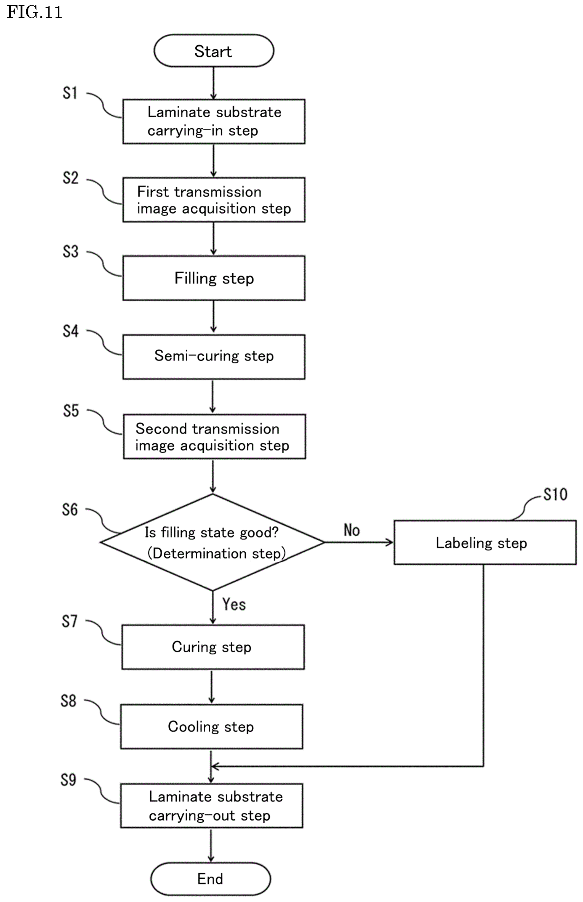

As shown in Fig. 11, the substrate treating method of the present embodiment is different in that in the labeling step S10, labeling is performed on a laminate substrate Ws determined as being defective in filling state of the filler in the determination step S6. Another difference is that the defective laminate substrate Ws is not refilled with the filler. Fig. 11 is a flowchart for illustrating a substrate treating method according to the present embodiment.

The substrate treating method of the present embodiment includes a laminate substrate carrying-in step S1, a first transmission image acquisition step S2, a filling step S3, a semi-curing step S4, a second transmission image acquisition step S5, a determination step S6, a labeling step S10, a curing step S7, a cooling step S8, and a laminate substrate carrying-out step S9 (see Fig. 11). Hereinafter, only the labeling step S10 will be described because other steps are the same as in the first embodiment.

### <Labeling step S10>

In the present step, labeling is performed on a laminate substrate Ws determined as being defective in filling state of the filler in the determination step S6. That is, the labeling unit 160 associates "defective" label data with the identifier of the laminate substrate Ws determined as being defective by the determination unit 158, followed by storage in a storage unit 159. In the curing step S7, the control unit 130' performs curing of the filler only on the laminate substrate Ws with an identifier with which label data is not associated. On the other hand, the controlling unit 130' does not perform the curing step S7 on a laminate substrate Ws having an identifier with which the label data is associated. The laminate substrate Ws is carried out the substrate treating unit 1 by instructing the second conveyance unit 111 to operate (laminate substrate carrying-out step S9). Thereafter, the unloaded defective laminate substrate Ws is discarded, for example.

As described above, in the present embodiment, labeling is performed on a laminate substrate Ws determined as being defective in filling state of the filler, so that subsequent steps such as a step of thinning the laminate substrate Ws and a step of trimming an end portion of the laminate substrate Ws are not performed. Therefore, in the present embodiment, occurrence of breakage or chipping of an end portion of the laminate substrate Ws and peeling of the substrate in subsequent steps can be prevented to improve the yield.

In the present embodiment, a case where labeling is performed only on a laminate substrate Ws determined as being defective in filling state of the filler has been described as an example, but labeling may also be performed on a laminate substrate Ws determined as being excellent in filling state of the filler.

### (Other matters)

In the above description, the most preferred embodiments of the present disclosure have been described. However, the present disclosure is not limited to these embodiments, and various modifications can be made as long as they are substantially consistent with the technical ideas described in claims of the present disclosure.

For example, in the first and second embodiments, the present disclosure has been described by showing as an example a method in which the quality of the filling state of the filler is determined by comparing the pixels of the binarized image data of the first transmission image and the binarized image data of the second transmission image. However, the present disclosure is not limited to this aspect, and it is also possible to confirm the filling state of the filler by, for example, a ratio of change in luminance calculated from the luminance of the pixel of the first transmission image and the luminance of the pixel of the second transmission image. The ratio of change in luminance of the pixel can be acquired by superimposing the first transmission image and the second transmission image. In this case, the ratio of change in luminance may be compared with a predetermined threshold, and when the ratio of change is above the threshold, it may be determined that the filling state is favorable. The second transmission image may be acquired to determine the filling state before the semi-curing step.

In the second embodiment, a case where a laminate substrate Ws determined as being defective in filling state of the filler and subjected to labeling is subsequently carried out the substrate treating unit 1 has been described as an example. However, the present disclosure is not limited to this aspect, and as in the substrate treating method of the first embodiment, refilling with the filler may be carried out by repeatedly performing the filling step S3, the semi-curing step S4, the second transmission image acquisition step S5, and the determination step S6 in sequence on the laminate substrate Ws subjected to labeling.

For example, in the present disclosure, as the inspection unit, a configuration based on an infrared observation method as described in the first and second embodiments, as well as a configuration based on a phase difference observation method can be utilized. When the phase difference observation method is utilized for the inspection unit, the inspection unit has, for example, a configuration in which a ring diaphragm is provided on the irradiation unit side, and a phase difference plate is provided on the imaging unit side.

## Claims

1. A substrate treating method in which a gap in a peripheral edge portion of a laminate substrate obtained by laminating a plurality of substrates is filled with a filler, the method comprising:
acquiring a first transmission image of the peripheral edge portion of the laminate substrate;
filling the gap in the peripheral edge portion of the laminate substrate after acquisition of the first transmission image with the filler;
acquiring a second transmission image of the peripheral edge portion after filling with the filler; and
determining a filling state of the filler by comparing the first transmission image and the second transmission image.

2. The substrate treating method according to claim 1, wherein
the acquisition of the first transmission image and the second transmission image comprises:
irradiating the peripheral edge portion of the laminate substrate in a substantially perpendicular direction with light having a wavelength that allows the light to pass through the laminate substrate, and acquiring the first transmission image or the second transmission image in plan view by receiving the light passing through the peripheral edge portion of the laminate substrate.

3. The substrate treating method according to claim 2, wherein
the acquisition of the first transmission image and the second transmission image comprises:
rotating the laminate substrate around a rotation axis, and sequentially acquiring a transmission image of a preset imaging region in the peripheral edge portion of the laminate substrate at each of predetermined rotation angles.

4. The substrate treating method according to claim 1, comprising
semi-curing the filler filling the gap in the peripheral edge portion of the laminate substrate after filling with the filler and before acquisition of the second transmission image.

5. The substrate treating method according to claim 4, wherein
when the filling state of the filler is determined as being defective in the determination, the filling with the filler, the semi-curing, the acquisition of the second transmission image, and the determination are repeated in sequence.

6. The substrate treating method according to claim 1, comprising
curing the filler when the filling state of the filler is determined as being favorable in the determination.

7. The substrate treating method according to claim 1, comprising
performing labeling on a laminate substrate determined as being defective in filling state of the filler in the determination.

8. A substrate treating apparatus for executing a substrate treating method in which a gap in a peripheral edge portion of a laminate substrate obtained by laminating a plurality of substrates is filled with a filler,
the substrate treating method comprising:
acquiring a first transmission image of the peripheral edge portion of the laminate substrate;
filling the gap in the peripheral edge portion of the laminate substrate after acquisition of the first transmission image with the filler;
acquiring a second transmission image of the peripheral edge portion after filling with the filler; and
determining a filling state of the filler by comparing the first transmission image and the second transmission image,
the substrate treating apparatus comprising:
a spin chuck that holds the laminate substrate;
a transmission image acquisition unit that acquires a transmission image of the peripheral edge portion of the laminate substrate;
a dispenser that fills a gap in the peripheral edge portion of the laminate substrate with the filler; and
a controller, wherein
the transmission image acquisition unit includes:
a light source that irradiates the peripheral edge portion of the laminate substrate with light having a wavelength that allows the light to pass through the laminate substrate; and
an imaging element that can receive light passing through the peripheral edge portion of the laminate substrate, and takes the first transmission image before filling of the gap with the filler by the dispenser and the second transmission image after filling with the filler, and
the controller determines the filling state of the filler by comparing the first transmission image and the second transmission image.

9. The substrate treating apparatus according to claim 8, wherein
the light source irradiates a surface of the laminate substrate in a substantially perpendicular direction with light having a wavelength that allows the light to pass through the laminate substrate, and
the imaging element takes the first transmission image or the second transmission image in plan view by receiving the light passing through the peripheral edge portion of the laminate substrate.

10. The substrate treating apparatus according to claim 8, wherein
the spin chuck rotates the laminate substrate around a rotation axis,
the light source irradiates a preset imaging region in the peripheral edge portion of the rotating laminate substrate at each of predetermined rotation angles, and
the imaging element sequentially takes the first transmission image and the second transmission image of the imaging region at each of the predetermined rotation angles.

11. The substrate treating apparatus according to claim 8, comprising
a heater or an ultraviolet irradiation device that semi-cures or cures the filler filling the gap in the peripheral edge portion of the laminate substrate.

12. The substrate treating apparatus according to claim 8, wherein
the controller performs labeling on a laminate substrate determined as being defective in filling state of the filler.
